# FASCICULE DE BREVET EUROPEEN

(11) **EP 3 724 927 B1**
(45) Date de publication et mention de la délivrance du brevet: **15.09.2021**
(21) Numéro de dépôt: 18836835.1
(22) Date de dépôt: 04.12.2018
(51) Int. Cl.: H01L 31/042, H01L 33/00, H02S 40/32, H02S 40/34, H02S 40/36, H01L 31/048, H02J 50/10, H02S 20/20, H02S 20/21

(54) **DALLE DE REVÊTEMENT POUR INFRASTRUCTURE FONCTIONNALISÉE**
ABDECKPLATTE FÜR FUNKTIONALISIERTE INFRASTRUKTUR
COVERING SLAB FOR FUNCTIONALISED INFRASTRUCTURE

(30) Priorité: 13.12.2017 FR 1762046
(43) Date de publication de la demande: 21.10.2020
(73) Titulaire: Commissariat à l'Énergie Atomique et aux Énergies Alternatives, 75015 Paris (FR); COLAS, 75015 Paris (FR)
(72) Inventeur: CHAINTREUIL, Nicolas, 73800 MONTMELIAN (FR); BARRUEL, Franck, 73370 LE BOURGET DU LAC (FR); COQUELLE, Eric, 78000 VERSAILLES (FR)
(74) Mandataire: Jacobacci Coralis Harle
(86) Numéro de dépôt international: PCT/FR2018/053099
(87) Numéro de publication internationale: WO 2019/115910

(56) Documents cités:
- CN-A- 107 142 815
- US-A1- 2005 199 282

## Description

### Domaine technique de l'invention

La présente invention se rapporte à une dalle de revêtement pour une infrastructure fonctionnalisée. L'invention concerne également un système de transmission d'énergie sans contact employant ladite dalle de revêtement ainsi qu'une infrastructure fonctionnalisée employant ledit système.

Par le terme "infrastructure", de manière non limitative, on entend une chaussée de type route ou autoroute, mais aussi un mur ou un toit.

Par le terme "fonctionnalisée", de manière non limitative, on entend l'apport d'une fonction de type générateur d'énergie électrique et/ou de type récepteur d'énergie électrique.

Il s'agira donc d'apporter, grâce à l'infrastructure, une ou plusieurs fonctions telles que génération d'énergie électrique par l'utilisation de cellules photovoltaïques, signalisation visuelle ou sonore, éclairage, mais aussi comptage de véhicule ou rechargement des batteries d'un véhicule électrique.

### Etat de la technique

Pour rentabiliser l'espace, notamment dans les agglomérations, il a été proposé de réaliser des routes qui intègrent des cellules photovoltaïques. Comme les routes sont souvent bien exposées au soleil, elles sont à même de pouvoir capter facilement l'énergie lumineuse. En leur intégrant des cellules photovoltaïques, elles peuvent convertir l'énergie lumineuse captée en énergie électrique. L'énergie électrique produite par les routes peut alors être employée de diverses manières. Des convertisseurs sont par exemple judicieusement positionnés au bord des routes pour renvoyer l'énergie électrique générée vers le réseau ou toute autre installation.

Les documents référencés FR3016257A1 et US8080901B2 décrivent de telles solutions de route fonctionnalisée à partir de cellules photovoltaïques ou de convertisseurs d'énergie de type piézoélectrique ou thermoélectrique.

Les documents WO2016/16165A1 et WO2016/16170A1 décrivent quant à eux une structure multicouches d'un module photovoltaïque, qui peut être employée pour réaliser la couche de roulement d'une chaussée fonctionnalisée. Cette structure multicouches présente notamment des caractéristiques mécaniques suffisantes pour absorber les chocs et subir les différentes sollicitations mécaniques d'une couche de roulement d'une chaussée.

Chacun des documents CN 107 142 815 A et US 2005/199282 A1 décrit une dalle de revêtement pour infrastructure fonctionnalisée formée d'un ensemble monobloc comportant un ensemble de fonctionnalisation électrique de ladite dalle comprenant une couche externe, et un bloc électronique connecté audit ensemble de fonctionnalisation électrique et comprenant au moins un convertisseur statique bidirectionnel.

Cependant, même si la perspective de fonctionnaliser les routes est particulièrement intéressante, celle-ci se heurte pour le moment à des difficultés de mise en oeuvre. Les connectiques électriques ont souvent tendance à s'user par oxydation. De plus, une fois l'infrastructure installée, sa maintenance et son entretien restent compliqués, le moindre dysfonctionnement nécessitant souvent de casser la route pour accéder aux parties défectueuses.

Il n'existe donc pour le moment aucune solution qui permette de réaliser une infrastructure fonctionnalisée qui soit fiable, peu couteuse, facile à installer et à entretenir.

Par ailleurs, les solutions existantes sont souvent peu adaptées pour répondre au problème de sécurité des personnes. En effet, considérant les contraintes mécaniques importantes subies par une route, il est impératif d'avoir un niveau de tension de type TBTS (pour Très Basse Tension de Sécurité) sur les premiers centimètres d'épaisseur de la chaussée (environ 5 centimètres) afin d'éviter tout risque d'électrocution en cas de dégradation de la chaussée. Par tension de type TBTS, on entend une tension inférieure à 60V. Idéalement, la tension supérieure (basse tension) ne doit être accessible qu'à partir d'une profondeur plus importante.

Le but de l'invention est de proposer une solution pour réaliser une infrastructure fonctionnalisée de manière simple, peu couteuse, qui soit facile à installer et à entretenir en cas de dysfonctionnement et qui permette de tenir compte des contraintes en termes de tension de sécurité évoquées ci-dessus.

### Exposé de l'invention

Ce but est atteint par une dalle de revêtement pour infrastructure telle qu'une chaussée de type route ou autoroute, un mur ou un toit, ladite infrastructure étant fonctionnalisée par l'apport d'une fonction de type générateur d'énergie électrique et/ou de type récepteur d'énergie électrique, ladite dalle étant formée d'un ensemble monobloc qui comporte :
- Un ensemble de fonctionnalisation électrique de ladite dalle comprenant une première couche, dite couche externe,
- Un bloc électronique connecté audit ensemble de fonctionnalisation électrique et comprenant au moins un convertisseur statique bidirectionnel,
- Un bloc de transmission d'énergie sans contact comportant un coupleur inductif doté de deux bornes connectées au convertisseur statique bidirectionnel dudit bloc électronique et présentant une surface de couplage située à l'opposé de ladite couche externe.

Selon une réalisation particulière, l'ensemble de fonctionnalisation électrique comporte un bloc générateur d'énergie électrique.

Selon une particularité, le bloc générateur d'énergie électrique peut comporter des cellules photovoltaïques destinées à convertir une énergie lumineuse en une énergie électrique.

Selon une autre réalisation particulière, l'ensemble de fonctionnalisation électrique comporte un bloc récepteur d'énergie électrique.

Selon une particularité, le bloc récepteur d'énergie électrique peut comporter un circuit électronique de signalisation lumineux et/ou sonore.

Selon une autre particularité, le bloc récepteur d'énergie électrique peut comporter un dispositif de recharge d'un appareil électrique par induction.

Selon une autre particularité, le bloc récepteur d'énergie électrique peut comporter un dispositif de comptage de véhicule.

Selon une autre particularité, le bloc récepteur d'énergie électrique peut comporter une ou plusieurs bornes de connexion à un ou plusieurs réseaux de communication sans fil.

Selon une autre particularité, le bloc récepteur d'énergie électrique peut comporter une structure chauffante.

L'invention concerne également un système de transmission d'énergie électrique sans contact pour infrastructure telle qu'une chaussée de type route ou autoroute, un mur ou un toit, ladite infrastructure étant fonctionnalisée par l'apport d'une fonction de type générateur d'énergie électrique et/ou de type récepteur d'énergie électrique, ledit système comprenant :
- Une première partie comportant n blocs de transmission d'énergie sans contact, comportant chacun un coupleur inductif, n étant supérieur ou égal à 1, chaque coupleur inductif comprenant une surface de couplage,
- Une deuxième partie comportant n dalle(s) de revêtement, chaque dalle de revêtement étant telle que définie ci-dessus.

Selon une réalisation particulière :
- La première partie comporte n blocs de transmission d'énergie sans contact, n étant supérieur ou égal à 2,
- Chaque coupleur inductif de la première partie est connecté électriquement à un coupleur inductif adjacent par l'intermédiaire d'un câble de liaison.

Selon une autre réalisation particulière, la première partie comporte n convertisseur(s) statiques, associés chacun à un coupleur inductif distinct de la première partie.

Selon une réalisation particulière, dans la première partie, les n convertisseur(s) statiques sont de type AC/DC et le système comporte un convertisseur central de type DC/AC et les n convertisseur(s) statiques de type AC/DC sont connectés en parallèle audit convertisseur central.

Selon une particularité, le système peut comporter un module de stockage d'énergie électrique connecté en parallèle des n convertisseur(s) connectés au convertisseur central.

Selon une autre réalisation particulière, dans la première partie, les n convertisseur(s) statique sont de type AC/AC.

Selon une autre réalisation particulière, le système comporte un convertisseur central de type AC/AC et en ce que les n coupleur(s) inductif(s) de la première partie sont connectés en parallèle audit convertisseur central AC/AC.

Selon une autre réalisation particulière, dans la première partie, les n convertisseur(s) statiques sont de type DC/AC et le système comporte un convertisseur central de type AC/AC et les n convertisseur(s) statiques de type DC/AC sont connectés en parallèle audit convertisseur central.

L'invention concerne également une infrastructure fonctionnalisée incluant un système de transmission d'énergie électrique sans contact, ladite infrastructure comportant une couche inférieure qui comporte une surface à recouvrir et dans laquelle est réalisée n cavité(s), n étant supérieur ou égal à 1, ladite infrastructure comportant :
- Une première partie comprenant un coupleur inductif logée dans chaque cavité de manière à présenter une première surface de couplage,
- Une deuxième partie comportant n dalle(s) de revêtement (2), telles que définies ci-dessus, chaque dalle de revêtement étant positionnée sur ladite surface à recouvrir de manière à recouvrir une cavité distincte et à présenter sa face externe vers l'extérieur de ladite cavité et sa surface de couplage vers l'intérieur de ladite cavité en vis-à-vis de ladite surface de couplage du coupleur inductif logé dans la cavité.

Selon une particularité :
- ladite surface à recouvrir de la couche inférieure (10) comporte n cavités, avec n supérieur ou égal à 2,
- ladite infrastructure comporte une tranchée reliant chaque cavité à une cavité adjacente,
- ladite première partie du système comporte plusieurs coupleurs inductifs logés chacun dans une cavité distincte,
- d'une cavité à une cavité adjacente, les coupleurs inductifs sont reliés entre eux par un câble de liaison s'étendant dans ladite tranchée.

Selon une autre particularité, les n dalles de revêtement sont juxtaposées de manière à présenter leur surface externe de leur couche externe située dans un même plan.

L'invention concerne également un procédé d'installation d'une infrastructure fonctionnalisée telle que définie ci-dessus, ledit procédé comportant des étapes :
- Réalisation de n cavités, n étant supérieur ou égal à 2, dans la couche inférieure,
- Positionnement de la première partie de manière à occuper chaque cavité par un coupleur inductif distinct,
- Positionnement d'une dalle de revêtement distincte au-dessus de chaque cavité de manière à présenter sa face externe vers l'extérieur de ladite cavité et sa surface de couplage vers l'intérieur de ladite cavité en vis-à-vis de ladite surface de couplage du coupleur inductif logé dans la cavité.

### Brève description des figures

D'autres caractéristiques et avantages vont apparaître dans la description détaillée qui suit faite en regard des dessins annexés dans lesquels :
- Les figures 1A et 1B représentent de manière schématique, respectivement en perspective et vue en coupe transversale, une dalle de revêtement conforme à l'invention.
- La figure 2 représente, en coupe transversale, les différentes couches d'un ensemble de fonctionnalisation électrique de la dalle de type module photovoltaïque.
- Les figures 3A et 3B représentent, respectivement vu en perspective et vu en coupe transversale, un bloc de transmission d'énergie sans contact employé dans le système de transmission d'énergie sans contact de l'invention.

- Les figures 4A à 4D illustrent les principales étapes de mise en oeuvre d'une infrastructure fonctionnalisée conforme à l'invention.
- Les figures 5A et 5B illustrent le principe d'installation de la première partie du système de l'invention.
- Les figures 6A et 6B représentent, vue de dessus et vu en coupe transversale, une infrastructure fonctionnalisée de type route dotée de plusieurs dalles adjacentes.
- Les figures 7 à 10 représentent plusieurs architectures électriques possibles du système de transmission d'énergie sans contact de l'invention.

### Description détaillée d'au moins un mode de réalisation

Dans la suite de la description, les termes "supérieur", "inférieur", "haut", "bas" ou autres termes équivalents sont à considérer en tenant compte d'un axe (A) qui sera défini comme perpendiculaire au plan formé par une dalle (axe vertical dans le plan de la feuille sur les figures annexées).

Comme décrit ci-dessus, par infrastructure, on entend par exemple une zone circulable.

Par "zone circulable", on entend, de manière non limitative, toute zone prévue pour la circulation de piétons et/ou de véhicules, telles que par exemple une chaussée de type route ou autoroute, une piste cyclable, un trottoir ou un parking.

On tiendra compte du fait que l'infrastructure 1 à fonctionnaliser comporte une couche inférieure 10, dotée d'une surface 100 à recouvrir d'une couche fonctionnelle qui permet à ladite infrastructure 1 d'être fonctionnalisée.

L'invention vise notamment à réaliser ladite couche fonctionnelle en employant des dalles de revêtement positionnées de manière adaptée, par exemple de manière adjacentes et jointives, pour recouvrir au moins partiellement la surface 100 de la couche inférieure 10 de ladite infrastructure 1. Les dalles sont par exemple toutes une forme identique, par exemple rectangulaire ou carrée.

Dans le cas d'une infrastructure de type zone circulable, la couche inférieure sera par exemple composée d'un enrobé. Bien entendu, cette couche inférieure ne faisant pas partie de l'invention, toute autre structure monocouche ou multicouches pourra être envisagée.

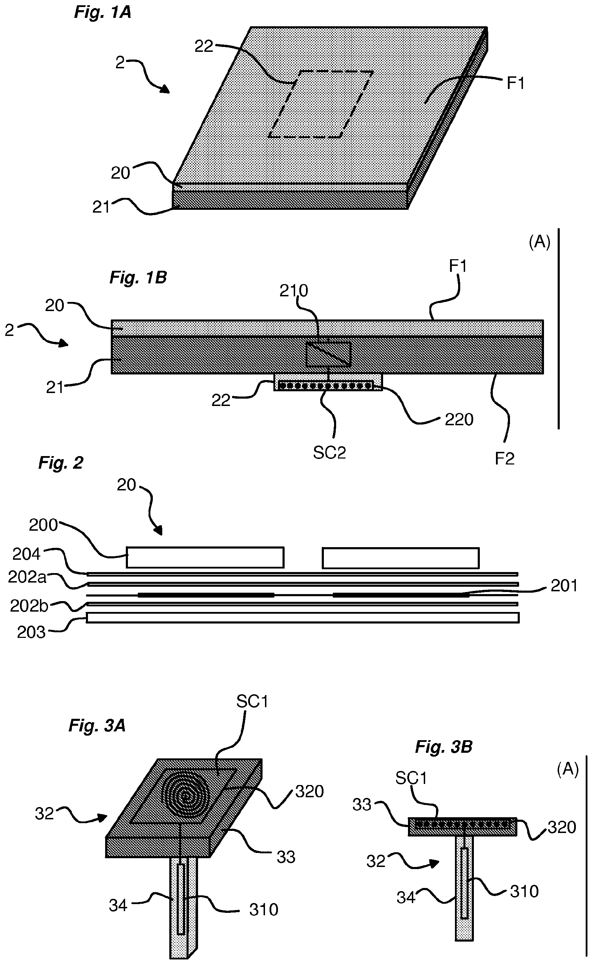

En référence aux figures 1A et 1B, une dalle de revêtement 2 conforme à l'invention comporte les caractéristiques décrites ci-dessous.

La dalle 2 de l'invention se présente sous la forme d'un élément monobloc, c'est-à-dire ne formant qu'une seule pièce. Elle présente avantageusement une première face, dite face supérieure F1, destinée à former la face externe de l'infrastructure et une face inférieure F2 opposée et préférentiellement parallèle à la face supérieure. Entre ses deux faces, la dalle comporte plusieurs ensembles ou blocs fonctionnels. Ces ensembles et blocs fonctionnels seront logés préférentiellement dans un ou plusieurs boîtiers hermétiques fixés entre eux et présentant, si nécessaire, des moyens de connexion électriques. Sa face supérieure F1 est avantageusement plane. Cette couche externe, définissant le contour de la dalle, pourra être de toute forme possible.

La dalle de revêtement 2 comporte ainsi un ensemble de fonctionnalisation électrique 20 qui permet de conférer à la dalle, exclusivement une fonction électrique de type générateur d'énergie électrique ou une fonction électrique de type récepteur d'énergie électrique (c'est-à-dire consommateur). L'infrastructure comportant plusieurs dalles de ce type pourra pour sa part être dotée d'une ou plusieurs fonctions, selon le type des dalles employées.

De manière non limitative, cet ensemble de fonctionnalisation électrique 20 de la dalle comporte une première couche 200 présentant une face supérieure, dite également face externe, formant la face supérieure F1 de la dalle 2 évoquée ci-dessus, et destinée à représenter la surface de roulement de la zone circulable.

La dalle de revêtement 2 comporte un bloc électronique 21 connecté à l'ensemble de fonctionnalisation électrique 20 et qui comporte au moins un convertisseur 210.

Dans le même élément monobloc, la dalle de revêtement 2 comporte également un bloc de transmission d'énergie sans contact 22 doté d'au moins un coupleur inductif. Ce bloc sera par exemple fixé contre la face inférieure F2 définie ci-dessus, par tous moyens de fixation possible et connectés électriquement aux différents circuits situés au-dessus de lui.

Selon l'invention, l'ensemble de fonctionnalisation électrique 20 pourra prendre différentes configurations selon la fonctionnalité de type générateur ou récepteur à apporter à la dalle et à l'infrastructure 1. Il faut noter que le bloc électronique 21 et le bloc de transmission d'énergie sans contact 22 de la dalle qui seront détaillés ci-après seront préférentiellement toujours identiques, quelle que soit la configuration de l'ensemble de fonctionnalisation électrique 20.

Dans une première configuration, conférant exclusivement à la dalle un type générateur d'énergie électrique, l'ensemble de fonctionnalisation électrique 20 se présente sous la forme d'un module photovoltaïque. Préférentiellement, il comporte la structure décrite dans les deux demandes de brevet n°WO2016/16165A1 et WO2016/16170A1 et représentée sur la figure 2. Sans rentrer dans les détails, dans cette structure de module photovoltaïque, la première couche 200 décrite ci-dessus est transparente sur toute son épaisseur de manière à laisser passer un flux lumineux.

Par le terme "transparent", on entend que le matériau formant la première couche est au moins partiellement transparent à la lumière visible.

La première couche 200 sera par exemple réalisée sous la forme d'une seule plaque ou de plusieurs plaques juxtaposées. Elle sera par exemple réalisée dans un matériau polymère transparent, tel que par exemple du Polyméthacrylate de Méthyle (PMMA).

Par ailleurs, le module photovoltaïque comporte une pluralité de cellules photovoltaïques 201 connectées entre elles en série ou en série/parallèle. De manière connue, celles-ci sont destinées à capter le flux lumineux qui traverse la première couche.

Le module photovoltaïque comporte un ensemble encapsulant dans lequel sont encapsulées les cellules photovoltaïques. Cet ensemble encapsulant est préférentiellement constituée de deux couches 202a, 202b de matériau d'encapsulation, entre lesquelles les cellules photovoltaïques sont encapsulées. Une opération de laminage est mise en oeuvre pour fondre les deux couches 202a, 202b d'encapsulation en une seule couche dans laquelle sont noyées les cellules photovoltaïques 201. Le procédé de fabrication est détaillé dans les deux demandes de brevet cités ci-dessus, incorporés ici par référence. Celui-ci ne faisant pas partie de l'invention, il n'est pas décrit précisément dans la présente demande.

Par le terme "encapsulant" ou "encapsulé" employé, il faut comprendre que les cellules photovoltaïques 201 sont logées dans un volume, préférentiellement hermétique, formé par l'assemblage des deux couches de l'ensemble.

Le module photovoltaïque comporte une deuxième couche 203, formant la face arrière du module. L'ensemble encapsulant est positionné entre la première couche 200 et cette deuxième couche 203. Cette deuxième couche 203 sera par exemple réalisée dans un matériau de type composite, par exemple de type polymère/fibres de verre.

Le module photovoltaïque comporte avantageusement une couche intermédiaire 204 dite "amortissante" située entre la première couche 200 et la couche supérieure 202a de l'ensemble encapsulant (202a, 202b) et permettant l'assemblage, notamment par collage, de la première couche 200 sur l'ensemble encapsulant.

Le module photovoltaïque comporte avantageusement une couche adhésive (non représentée) située entre l'ensemble encapsulant et la deuxième couche 203. Cette couche servira à l'assemblage, notamment par collage, de la deuxième couche 203 sur l'ensemble encapsulant.

Selon d'autres configurations définies ci-dessous, l'ensemble de fonctionnalisation électrique pourra comporter de manière exclusive un circuit récepteur d'énergie électrique.

Ainsi, dans une deuxième configuration, l'ensemble de fonctionnalisation électrique 20 peut comporter un circuit électronique de signalisation lumineux et/ou sonore.

Le circuit électronique de signalisation lumineux comporte par exemple une ou plusieurs diodes lumineuses permettant de fournir un éclairage.

Dans cette deuxième configuration, la structure de l'ensemble de fonctionnalisation électrique 20 est similaire à celle de la première configuration de type photovoltaïque. Les différences résident dans le fait qu'il emploie un bloc de signalisation incluant des diodes lumineuses.

Dans une troisième configuration, l'ensemble de fonctionnalisation électrique peut comporter un module de recharge de véhicule électrique par induction. Cette solution permet de recharger un véhicule électrique lorsque celui-ci est immobile sur la chaussée ou sur une place de parking.

Dans une quatrième configuration, l'ensemble de fonctionnalisation électrique peut comporter une ou plusieurs prises électriques de manière à y brancher tous types d'appareils électriques.

Dans une cinquième configuration, l'ensemble de fonctionnalisation électrique peut comporter tous types de capteurs, par exemple de type capteur de température ou de type comptage de véhicules.

Dans une sixième configuration, l'ensemble de fonctionnalisation électrique peut comporter une ou plusieurs bornes de connexion à un ou plusieurs réseaux de communication sans fil. Il s'agira par exemple d'une borne fonctionnant selon un protocole de communication connu tel que WIFI, Bluetooth, 3G, 4G ou autre protocole équivalent. Il s'agira alors de proposer une dalle dotée d'une ou plusieurs de ces fonctions de communication.

Dans une septième configuration, l'ensemble de fonctionnalisation électrique peut comporter une structure chauffante comprenant par exemple des résistances ou une résille permettant de chauffer l'infrastructure, pour notamment la dégivrer en hiver.

Pour répondre à l'ensemble des fonctions de type générateur ou récepteur, la dalle de revêtement 2 de l'invention comporte en outre un bloc électronique 21 qui comporte au moins un convertisseur 210 de tension statique qui est bidirectionnel en courant. Grâce à ce convertisseur, selon sa fonction, la dalle 2 pourra agir comme générateur de courant ou comme récepteur de courant.

Pour un ensemble de fonctionnalisation électrique 20 à cellules photovoltaïques, le convertisseur de tension sera ainsi de type DC/AC pour convertir le courant continu fourni par les cellules photovoltaïques en courant alternatif.

Pour un ensemble de fonctionnalisation électrique 20 de type récepteur, le convertisseur sera d'une topologie adaptée au type de récepteur employé. Par exemple, si le récepteur est un circuit électronique de signalisation, le convertisseur de tension sera de type AC/DC, le circuit électronique de signalisation étant connecté côté DC.

Pour un ensemble de fonctionnalisation électrique 20 disposant d'un module de recharge électrique par induction d'un véhicule électrique, le convertisseur sera de type AC/AC.

Pour un ensemble de fonctionnalisation électrique 20 à structure chauffante, le convertisseur de tension sera de type AC/AC.

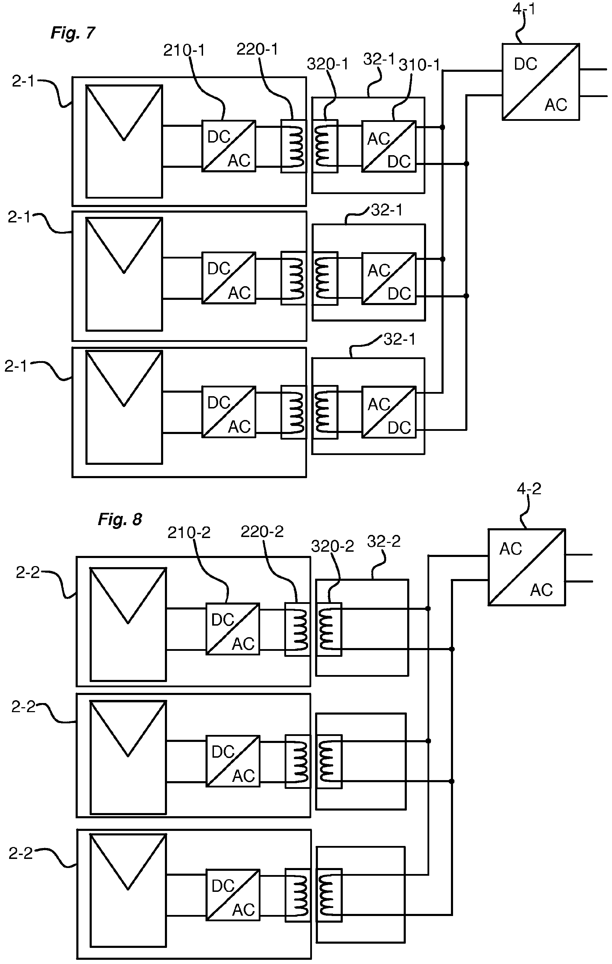

En référence aux figures 7 à 10, on détaillera ci-dessous les différentes configurations électriques envisageables sur différents exemples d'infrastructures fonctionnalisées.

La dalle 2 comporte enfin un bloc de transmission d'énergie sans contact 22 qui comporte un coupleur inductif 220. De manière connue, ce coupleur inductif 220 comporte un enroulement de spires et est destiné à être positionné en vis-à-vis d'un deuxième coupleur inductif pour réaliser un transfert d'énergie électrique sans contact, c'est-à-dire sans fil, par couplage électromagnétique. L'un des deux coupleurs forme ainsi le primaire d'un transformateur et l'autre des deux coupleurs forme le secondaire du transformateur. Selon la nature de l'ensemble de fonctionnalisation électrique de la dalle, le transfert d'énergie entre les deux coupleurs sera réalisé dans un sens ou dans l'autre. Si l'ensemble de fonctionnalisation électrique comporte un générateur de courant (par exemple un module photovoltaïque), le transfert d'énergie sera réalisé du coupleur inductif de la dalle vers le deuxième coupleur. En revanche, si l'ensemble de fonctionnalisation électrique comporte un ou plusieurs récepteurs (par exemple des diodes lumineuses), le transfert d'énergie se fera dans l'autre sens, c'est-à-dire du deuxième coupleur vers le coupleur de la dalle.

L'agencement du coupleur inductif 220 dans le bloc de transmission d'énergie sans contact 22 définit une surface de couplage SC2 située à l'opposé de la face supérieure F1 de la dalle et avantageusement parallèle à la face inférieure F2 de la dalle.

Le coupleur inductif 220 comporte deux bornes qui sont connectées au convertisseur de tension 210 du bloc 21 évoqué ci-dessus.

Le bloc de transmission d'énergie sans contact 22 peut être réalisé sous la forme d'un élément indépendant fixé sur la dalle 2 ou être intégré au bloc électronique décrit ci-dessus. Le bloc 22 peut notamment comporter un boîtier indépendant enfermant le coupleur inductif 220 ou être logé dans un même boîtier avec le bloc électronique 21.

L'enroulement formant le coupleur inductif 220 pourra être réalisée selon différentes configurations. Il s'agira par exemple d'une bobine de type planaire dont le plan défini par la bobine définit la surface de couplage évoquée ci-dessus. L'enroulement de la bobine planaire est par exemple réalisé par sérigraphie sur un circuit imprimé. L'une des faces du circuit imprimé forme alors la surface de couplage définie ci-dessus.

L'invention réside également dans le système de transmission d'énergie sans contact (autrement dit sans-fil) dans lequel est incluse une ou plusieurs dalles de revêtement 2 du type décrit ci-dessus.

Ce système se compose ainsi de deux parties, une première partie 3 et une deuxième partie, entre lesquelles la transmission d'énergie sans contact est opérée.

La deuxième partie du système est formée de n dalles de revêtement 2 telles que décrites ci-dessus, n étant supérieur ou égal à 1. Dans le cas où le nombre n de dalles est supérieur ou égal à deux, toutes les dalles de revêtement 2 employées dans cette deuxième partie du système pourront être de fonctions identiques, proposant alors une seule fonctionnalité au système (par exemple des dalles de type photovoltaïque uniquement), ou de fonctions différentes de manière à proposer plusieurs fonctionnalités au système (par exemple un mélange de dalles de type photovoltaïque avec des dalles ayant un ensemble de fonctionnalisation de type récepteur (ex : diodes lumineuses).

En référence aux figures 3A et 3B, la première partie 3 du système comporte pour sa part n blocs de transmission d'énergie sans contact 32, n étant supérieur ou égal à 1. Chaque bloc 32 comporte un coupleur inductif 320. Chaque coupleur inductif 320 de cette première partie est destiné à être associé à un coupleur inductif 220 distinct de la deuxième partie. Le coupleur inductif 320 employé dans la première partie comportera une architecture mécanique identique à celle du coupleur inductif de la dalle à laquelle il est associé. Il présente ainsi une surface de couplage SC1 destinée à être positionnée en parallèle de la surface de couplage SC2 de la dalle de manière à assurer un transfert d'énergie sans contact. Les caractéristiques de positionnement entre deux enroulements, pour obtenir le meilleur rendement possible de transfert d'énergie sans contact, sont bien connues dans l'état de la technique et ne sont donc pas décrites dans la présente demande. Cependant, on peut noter que la solution de positionnement retenue sera optimale suivant l'axe x et l'axe y et éventuellement variable dans la troisième dimension (suivant la hauteur définie par l'axe z). Les documents qui concernent notamment des solutions de recharge par induction décrivent de telles caractéristiques.

Pour loger chaque bloc de transmission d'énergie sans contact 32, la première partie 3 comporte avantageusement un ou plusieurs boîtiers. Dans la suite de la description, on considérera que chaque bloc de transmission d'énergie sans contact présente une structure dans laquelle le coupleur inductif 320 est logé dans un premier boîtier 33 qui comporte au moins une paroi définissant une face externe, préférentiellement plane, et une face interne en vis-à-vis de laquelle est positionnée la surface de couplage SC1 du coupleur inductif 320 du bloc. Ce premier boîtier sera avantageusement hermétique et particulièrement résistant pour être employé dans une infrastructure telle que l'une de celles décrites ci-dessus.

Selon la configuration du système, le bloc de transmission d'énergie sans contact 32 pourra comporter un convertisseur statique 310 adapté comprenant deux bornes de connexion entre lesquelles est connecté le coupleur inductif 320. Ce convertisseur statique 310 sera de type AC/DC ou AC/AC, le coupleur inductif étant connecté côté AC. Le bloc comporte avantageusement un deuxième boîtier 34, dans lequel est logé ledit convertisseur statique 310. Ce deuxième boîtier est fixé au premier boîtier. Les deux boîtiers sont par exemple fixés l'un sur l'autre. Le deuxième boîtier s'étend sous le premier boîtier à l'opposé de la surface de couplage. Des moyens de connexion électrique sont prévus pour assurer la connexion électrique entre le coupleur inductif et le convertisseur.

Bien entendu, dans le bloc de transmission d'énergie sans contact 32, tout autre agencement du coupleur inductif et du convertisseur pourrait être envisagé. L'avantage de la mise en oeuvre citée ci-dessus repose sur une gestion thermique plus aisée du convertisseur statique dans l'enrobé, car plus éloigné des contraintes thermiques extérieures.

Chaque bloc de transmission d'énergie sans contact 32 de la première partie 3 est connecté électriquement ou incluse dans une architecture électrique. Cette architecture électrique pourra différer, notamment selon les fonctions des dalles 2 employées.

En référence à la figure 7, une première architecture électrique (identifiée par l'indice 1 dans les références) du système est la suivante :
- Une première partie 3 qui comporte n blocs de transmission d'énergie sans contact 32-1, n étant supérieur ou égal à 1 (sur la figure 7, n=3). Chaque bloc de transmission d'énergie sans contact embarque un coupleur inductif 320-1 et un convertisseur 310-1 statique de type AC/DC, ledit coupleur inductif étant connecté du côté AC du convertisseur 310-1.
- Une deuxième partie comportant n dalles de revêtement 2-1 à ensemble de fonctionnalisation électrique de type module photovoltaïque. Chaque dalle de revêtement 2-1 embarque dans son bloc électronique un convertisseur 210-1 de type DC/AC, le module photovoltaïque étant connecté côté DC du convertisseur et le coupleur inductif 220-1 de la dalle côté AC du convertisseur.
- Un convertisseur central 4-1 de type DC/AC et un bus DC à deux lignes, sur lequel sont connectés en parallèle les convertisseurs 310-1 de type AC/DC de la première partie 3-1.

Cette première architecture permet notamment de travailler à fréquence relativement élevée (au moins 100 kHz) au niveau des coupleurs, permettant de garantir un rendement de couplage le plus élevé possible, tout en conservant une architecture de couplage (formée par les deux coupleurs en vis-à-vis) relativement compacte. En effet, plus la fréquence de transmission est élevée, plus les coupleurs employés pourront être compacts à iso-puissance, leur volume étant directement liée à leur fréquence d'utilisation.

En référence à la figure 8, une deuxième architecture (identifiée par l'indice 2 dans les références) du système électrique est la suivante :
- Une première partie 3-2 qui comporte n blocs de transmission d'énergie sans contact 32-2, n étant supérieur ou égal à 1 (sur la figure 8, n=3). Chaque bloc de transmission d'énergie sans contact embarque un coupleur inductif.
- Une deuxième partie comportant n dalles de revêtement 2-2 à ensemble de fonctionnalisation électrique de type module photovoltaïque. Chaque dalle de revêtement embarque dans son bloc électronique un convertisseur 210-2 de type DC/AC, le module photovoltaïque étant connecté côté DC du convertisseur et le coupleur inductif 220-2 de la dalle côté AC du convertisseur.
- Un convertisseur central 4-2 de type AC/AC et un bus de type AC à deux lignes, sur lequel sont connectés en parallèle les coupleurs inductifs de la première partie.

Cette deuxième architecture du système n'utilise pas de convertisseurs dans sa première partie mais utilise un convertisseur central 4-2 de type AC/AC auquel sont reliés en parallèle les coupleurs de la première partie. Cette architecture présente l'avantage de réduire le nombre de convertisseurs de puissance employés. La fréquence sur le bus AC sera de quelques kHz. Il conviendra d'adopter un compromis entre les différents paramètres que sont la fréquence sur le bus AC, le rendement de chaque coupleur inductif de la première partie et les pertes en lignes.

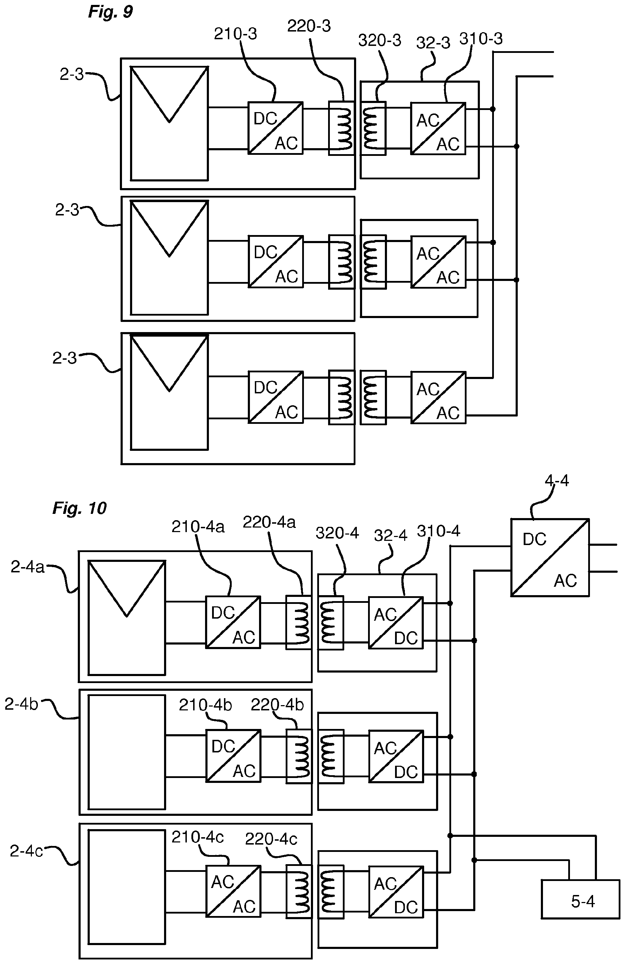

En référence à la figure 9, une troisième architecture électrique (identifiée par l'indice 3 dans les références) du système est la suivante :
- Une première partie 3-3 qui comporte n blocs de transmission d'énergie sans contact 32-3, n étant supérieur ou égal à 1 (sur la figure 9, n=3). Chaque bloc de transmission d'énergie sans contact embarque un coupleur inductif 320-3 et un convertisseur 310-3 de tension de type AC/AC, ledit coupleur inductif étant connecté du côté AC du convertisseur.
- Une deuxième partie comportant n dalles de revêtement 2-3 à ensemble de fonctionnalisation électrique de type module photovoltaïque. Chaque dalle de revêtement embarque dans son bloc électronique un convertisseur 210-3 de type DC/AC, le module photovoltaïque étant connecté côté DC du convertisseur et le coupleur inductif 220-3 de la dalle côté AC du convertisseur.

Cette troisième architecture s'affranchit du convertisseur central des architectures précédentes.

En référence à la figure 10, une quatrième architecture électrique (identifiée par l'indice 4 dans les références) du système est la suivante :
- Une première partie 3-4 qui comporte n blocs de transmission d'énergie sans contact 32-4, n étant supérieur ou égal à 1 (sur la figure 10, n=3). Chaque bloc de transmission d'énergie sans contact embarque un coupleur inductif 320-4 et un convertisseur 310-4 de tension de type AC/DC, ledit coupleur inductif 320-4 étant connecté du côté AC du convertisseur.
- Une deuxième partie comportant n dalles de revêtement 2-4, les dalles de revêtements étant dotées de d'ensembles de fonctionnalisation électrique distincts. Une première dalle 2-4a comporte un ensemble de fonctionnalisation électrique de type module photovoltaïque. Une deuxième dalle 2-4b comporte un ensemble de fonctionnalisation électrique de type récepteur à signalisation lumineuse à base de diodes D. Une troisième dalle 2-4c comporte un ensemble de fonctionnalisation électrique de type récepteur à module de recharge de véhicule électrique par induction Mch. La première dalle 2-4a embarque dans son bloc électronique 21-4a un convertisseur 210-4a de type DC/AC, le module photovoltaïque étant connecté côté DC du convertisseur et le coupleur inductif de la dalle côté AC du convertisseur 210. La deuxième dalle 2-4b embarque dans son bloc électronique un convertisseur 210-4b de type DC/AC, le bloc de signalisation étant connecté côté DC du convertisseur et le coupleur inductif de la dalle côté AC du convertisseur. La troisième dalle 2-4c embarque dans son bloc électronique un convertisseur 210-4c de type AC/AC, le module de recharge par induction étant connecté côté AC du convertisseur et le coupleur inductif de la dalle côté AC du convertisseur.

- Un convertisseur central 4-4 de type DC/AC et un bus DC à deux lignes lesquels sont connectés en parallèle chaque convertisseur de type AC/DC de la première partie.
- Un module de stockage d'énergie électrique 5-4 connecté sur le bus DC.

Cette quatrième architecture permet de montrer quelle serait la structure du système dans une infrastructure fonctionnalisée dotée de dalles à plusieurs fonctions distinctes (photovoltaïque, signalisation, recharge par induction...). Elle n'est en rien limitative dans le nombre de fonctions disponibles et dans les fonctions proposées. Dans cette architecture, l'ensemble des convertisseurs est bidirectionnel en courant afin de permettre notamment le stockage de l'énergie dans le module de stockage et l'utilisation de l'énergie stockée dans ce module.

Bien entendu, d'autres architectures pourraient être envisagées et on comprend bien que l'invention ne se limite pas aux architectures décrites ci-dessus.

L'invention consiste également en l'agencement du système décrit ci-dessus pour son utilisation dans une infrastructure fonctionnalisée.

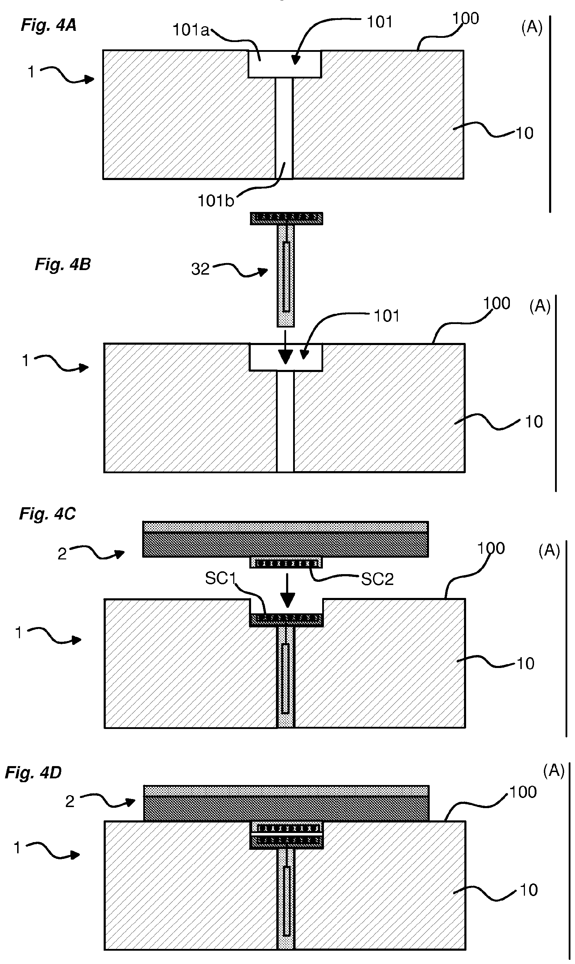

Comme déjà décrit ci-dessus, une infrastructure telle qu'une route comporte par exemple une couche inférieure 10 dotée d'une surface 100 à recouvrir. Selon un aspect de l'invention, cette surface 100 à recouvrir est destinée à être recouverte, au moins en partie, par les dalles de revêtement 2 de l'invention. Par ailleurs, pour loger la première partie 3 du système, la solution consiste à réaliser n cavités 101 ou trous dans la couche inférieure 10 de l'infrastructure, n étant supérieur ou égal à 1 (figure 4A). Chaque cavité est destinée à recevoir un bloc de transmission d'énergie sans contact 32 de la première partie du système, chaque bloc 32 étant positionné dans la cavité de manière à orienter la surface de couplage SC1 de son coupleur inductif 320 vers le haut (figure 4B).

De manière avantageuse, chaque cavité 101 est toujours réalisée avec des dimensions standards, c'est-à-dire profondeur, section à l'ouverture, forme de ladite section.

L'ouverture de la cavité 101 est ensuite recouverte par une dalle 2 (figures 4C et 4D). Des moyens mécaniques de positionnement et de centrage sont préférentiellement agencés pour permettre un positionnement et centrage parfaits de la dalle 2 par rapport à la cavité 101. Il s'agira par exemple de réaliser le boîtier de la dalle qui enferme le coupleur inductif avec des dimensions adaptées pour que celui-ci coopère, avec un jeu minimal, avec le bord de l'ouverture supérieure de la cavité.

La profondeur de chaque cavité est adaptée pour que la surface de couplage SC1 du bloc 32 soit située à une hauteur suffisante pour favoriser la transmission d'énergie entre les deux coupleurs 220, 320.

Autrement dit, il faut que les deux coupleurs 220, 320 soient disposés bien en face l'un de l'autre suivant les axes x et y et respecter un espace entre eux suivant l'axe z adapté pour garantir un rendement de couplage satisfaisant.

En référence à la figure 4A, chaque cavité 101 présente par exemple une forme définissant une partie supérieure 101a de section constante, prolongée d'une partie inférieure 101b rétrécie par rapport à la partie supérieure et également de section constante. La partie inférieure de la cavité est destinée à recevoir le deuxième boîtier 34 du bloc de transmission d'énergie sans contact et la partie supérieure est destinée à recevoir le premier boîtier 33 du bloc de transmission d'énergie sans contact.

Selon l'invention, lorsque le système comporte une première partie à n blocs de transmission d'énergie et donc n coupleurs inductifs, avec n supérieur ou égal à 2, l'infrastructure est dotée de n cavités du type de celle décrite ci-dessus de manière à accueillir chacune un bloc de transmission d'énergie sans contact 32 distinct.

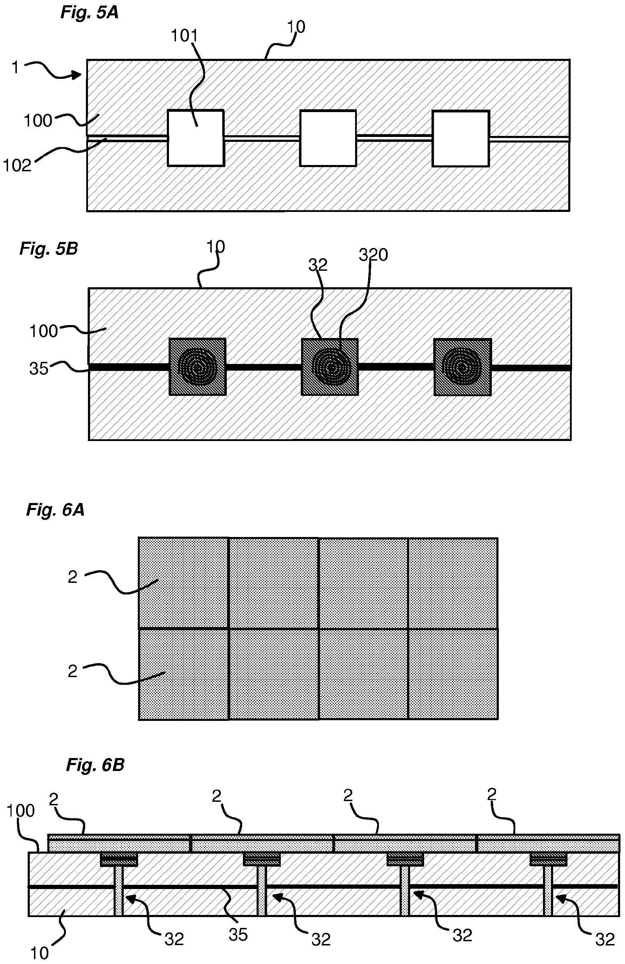

Selon l'invention, en référence aux figures 5A et 5B, l'infrastructure comporte une tranchée 102 réalisée dans la couche inférieure 10 et reliant chaque cavité 101 à une cavité adjacente.

Selon l'invention, dans le système chaque bloc de transmission d'énergie sans contact 32 de la première partie est ainsi connecté au bloc adjacent par au moins un câble de liaison 35, formant une forme de bus selon l'une des architectures électriques présentées ci-dessus. Et chaque câble de liaison 35 s'étend dans une tranchée 102 reliant deux cavités (figure 5B). La câble pourra prendre toute forme adaptée et sera connecté d'un bloc à l'autre. Il pourra s'agir par exemple d'une nappe de fils flexible.

Grâce à l'architecture du système et à celle de l'infrastructure, la réalisation d'une infrastructure fonctionnalisée est simple. Il s'agit en effet de mettre en oeuvre les étapes suivantes :
- Creuser plusieurs cavités 101 et plusieurs tranchées, une tranchée reliant une cavité à une cavité adjacente. Chaque cavité 101 prend par exemple la forme décrite ci-dessus à deux volumes superposées distincts de manière à former un rétrécissement.
- Positionner la première partie 3 du système de de sorte que chaque bloc de transmission d'énergie sans contact 32 soit positionné dans une cavité distincte. La surface de couplage SC1 du bloc est positionnée vers le haut.
- Positionner une dalle de revêtement au-dessus de chaque cavité 101, de manière à recouvrir au moins partiellement la surface 100 de la couche inférieure 10, la surface de couplage SC2 de la dalle étant positionnée parallèlement à la surface SC1 et à une distance imposée par le positionnement mécanique de la dalle, cette distance étant adaptée pour permettre une transmission d'énergie sans contact avec le meilleur rendement possible.

La figure 6A montre ainsi une surface entièrement recouverte de dalles 2 selon l'invention. La figure 6B montre pour sa part les dalles positionnées de manière adjacente sur la surface 100 de la couche inférieure 10. Les surfaces externes des n dalles positionnées de manière juxtaposée sont agencées dans un même plan, formant le plan de la chaussée. Les n dalles posées sur la couche inférieure sont donc ajustées les unes par rapport aux autres, notamment en termes de dimensions, pour être parfaitement jointives et paver ainsi au maximum la surface à recouvrir de la couche inférieure.

L'invention présente ainsi un certain nombre d'avantages, parmi lesquelles :
- Une facilité de réalisation d'une infrastructure fonctionnalisée, par le simple positionnement de dalles fonctionnalisées.
- Une possibilité de configurer l'infrastructure en mixant plusieurs types de dalles, tout en conservant un même mode d'installation.
- La possibilité de maintenir les basses tensions à l'abri de la surface et en maintenant une tension basse (TBTS) sur les premiers centimètres d'épaisseur de la chaussée.
- Une infrastructure facile à entretenir, grâce notamment à la possibilité de remplacer une dalle défaillante aisément, sans avoir à toucher à toute l'infrastructure.

## Revendications

1. Dalle de revêtement (2) pour infrastructure telle qu'une chaussée de type route ou autoroute, un mur ou un toit, ladite infrastructure étant fonctionnalisée par l'apport d'une fonction de type générateur d'énergie électrique et/ou de type récepteur d'énergie électrique, la dalle de revêtement étant formée d'un ensemble monobloc comportant:
- Un ensemble de fonctionnalisation électrique (20) de ladite dalle comprenant une première couche, dite couche externe,
- Un bloc électronique (21) connecté audit ensemble de fonctionnalisation électrique et comprenant au moins un convertisseur (210) statique bidirectionnel,
**caractérisée en ce que** ledit ensemble monobloc comporte également:
- Un bloc de transmission d'énergie sans contact (22) comportant un coupleur inductif (220) doté de deux bornes connectées au convertisseur statique bidirectionnel dudit bloc électronique (21) et présentant une surface de couplage située à l'opposé de ladite couche externe.

2. Dalle de revêtement selon la revendication 1, **caractérisée en ce que** l'ensemble de fonctionnalisation électrique comporte un bloc générateur d'énergie électrique.

3. Dalle de revêtement selon la revendication 2, **caractérisée en ce que** le bloc générateur d'énergie électrique comporte :
- des cellules photovoltaïques (201) destinées à convertir une énergie lumineuse en une énergie électrique.

4. Dalle de revêtement selon la revendication 1, **caractérisée en ce que** l'ensemble de fonctionnalisation électrique comporte un bloc récepteur d'énergie électrique.

5. Dalle de revêtement selon la revendication 4, **caractérisée en ce que** le bloc récepteur d'énergie électrique comporte un circuit électronique de signalisation lumineux et/ou sonore.

6. Dalle de revêtement selon la revendication 4, **caractérisée en ce que** le bloc récepteur d'énergie électrique comporte un dispositif de recharge d'un appareil électrique par induction.

7. Dalle de revêtement selon la revendication 4, **caractérisée en ce que** le bloc récepteur d'énergie électrique comporte un dispositif de comptage de véhicule.

8. Dalle de revêtement selon la revendication 4, **caractérisé en ce que** le bloc récepteur d'énergie électrique comporte une ou plusieurs bornes de connexion à un ou plusieurs réseaux de communication sans fil.

9. Dalle de revêtement selon la revendication 4, **caractérisé en ce que** le bloc récepteur d'énergie électrique comporte une structure chauffante.

10. Système de transmission d'énergie électrique sans contact pour infrastructure telle qu'une chaussée de type route ou autoroute, un mur ou un toit, ladite infrastructure étant fonctionnalisée par l'apport d'une fonction de type générateur d'énergie électrique et/ou de type récepteur d'énergie électrique, **caractérisé en ce qu'**il comporte :
- Une première partie (3) comportant n blocs de transmission d'énergie sans contact (32), comportant chacun un coupleur inductif, n étant supérieur ou égal à 1, chaque coupleur inductif (320) comprenant une surface de couplage (SC1),
- Une deuxième partie comportant n dalle(s) de revêtement (2), chaque dalle de revêtement étant telle que définie dans l'une des revendications 1 à 9.

11. Système selon la revendication 10, **caractérisé en ce que** :
- La première partie (3) comporte n blocs de transmission d'énergie sans contact, n étant supérieur ou égal à 2,
- Chaque coupleur inductif (320) de la première partie est connecté électriquement à un coupleur inductif adjacent par l'intermédiaire d'un câble de liaison (35).

12. Système selon la revendication 10 ou 11, **caractérisé en ce que** la première partie comporte n convertisseur(s) statiques (310), associés chacun à un coupleur inductif (320) distinct de la première partie.

13. Système selon la revendication 12, **caractérisé en ce que**, dans la première partie, les n convertisseur(s) statiques sont de type AC/DC et **en ce que** le système comporte un convertisseur central (4) de type DC/AC et **en ce que** les n convertisseur(s) statiques de type AC/DC sont connectés en parallèle audit convertisseur central.

14. Système selon la revendication 13, **caractérisé en ce qu'**il comporte un module de stockage d'énergie électrique (5) connecté en parallèle des n convertisseur(s) connectés au convertisseur central (4).

15. Système selon la revendication 12, **caractérisé en ce que**, dans la première partie, les n convertisseur(s) statique (310) sont de type AC/AC.

16. Système selon la revendication 12, **caractérisé en ce qu'**il comporte un convertisseur central (4) de type AC/AC et **en ce que** les n coupleur(s) inductif(s) de la première partie sont connectés en parallèle audit convertisseur central AC/AC.

17. Système selon la revendication 12, **caractérisé en ce que**, dans la première partie, les n convertisseur(s) statiques sont de type DC/AC et **en ce que** le système comporte un convertisseur central (4) de type AC/AC et **en ce que** les n convertisseur(s) statiques de type DC/AC sont connectés en parallèle audit convertisseur central.

18. Infrastructure telle qu'une chaussée de type route ou autoroute, un mur ou un toit, ladite infrastructure étant fonctionnalisée par l'apport d'une fonction de type générateur d'énergie électrique et/ou de type récepteur d'énergie électrique et incluant un système de transmission d'énergie électrique sans contact, ladite infrastructure comportant une couche inférieure (10) qui comporte une surface (100) à recouvrir et dans laquelle est réalisée n cavité(s) (101), n étant supérieur ou égal à 1, ladite infrastructure étant **caractérisée en ce qu'**elle comporte :
- Une première partie (3) comprenant un coupleur inductif (320) logée dans chaque cavité (101) de manière à présenter une première surface de couplage (SC1),
- Une deuxième partie comportant n dalle(s) de revêtement (2), telles que définies dans l'une des revendications 1 à 9, chaque dalle de revêtement (2) étant positionnée sur ladite surface (100) à recouvrir de manière à recouvrir une cavité (101) distincte et à présenter sa face externe vers l'extérieur de ladite cavité et sa surface de couplage (SC2) vers l'intérieur de ladite cavité en vis-à-vis de ladite surface de couplage (SC1) du coupleur inductif logé dans la cavité.

19. Infrastructure fonctionnalisée selon la revendication 18, **caractérisé en ce que** :
- ladite surface (100) à recouvrir de la couche inférieure (10) comporte n cavités, avec n supérieur ou égal à 2,
- ladite infrastructure comporte une tranchée (102) reliant chaque cavité (101) à une cavité adjacente,
- ladite première partie du système comporte plusieurs coupleurs inductifs (320) logés chacun dans une cavité (101) distincte,
- d'une cavité à une cavité adjacente, les coupleurs inductifs (320) sont reliés entre eux par un câble de liaison (35) s'étendant dans ladite tranchée (102).

20. Infrastructure fonctionnalisée selon la revendication 18 ou 19, **caractérisée en ce que** les n dalles de revêtement sont juxtaposées de manière à présenter leur surface externe de leur couche externe située dans un même plan.

21. Procédé d'installation d'une infrastructure fonctionnalisée telle que définie dans l'une des revendications 18 à 20, ledit procédé comportant des étapes :
- Réalisation de n cavités (101), n étant supérieur ou égal à 2, dans la couche inférieure,
- Positionnement de la première partie de manière à occuper chaque cavité par un coupleur inductif (320) distinct,
- Positionnement d'une dalle de revêtement (2) distincte au-dessus d'une cavité (101) distincte de manière à présenter sa face externe vers l'extérieur de ladite cavité et sa surface de couplage (SC2) vers l'intérieur de ladite cavité en vis-à-vis de ladite surface de couplage (SC1) du coupleur inductif logé dans la cavité.

## Patentansprüche

1. Abdeckplatte (2) für eine Infrastruktur wie etwa eine Chaussee vom Typ einer Straße oder einer Autobahn, eine Mauer oder ein Dach, wobei die Infrastruktur durch das Hinzufügen einer Funktion vom Typ eines Generators elektrischer Energie und/oder vom Typ eines Empfängers elektrischer Energie funktionalisiert ist, wobei die Abdeckplatte aus einer einstückigen Vorrichtung gebildet ist, die
- eine Vorrichtung (20) zum elektrischen Funktionalisieren der Abdeckplatte, die eine erste Schicht, die sogenannte äußere Schicht, aufweist,
- einen elektronischen Block (21), der mit der Vorrichtung zum elektrischen Funktionalisieren verbunden ist und wenigstens einen statischen bidirektionalen Wandler (210) aufweist,
aufweist,
**dadurch gekennzeichnet, daß** die einstückige Vorrichtung außerdem
- einen Block (22) zum kontaktlosen Übertragen von Energie aufweist, der einen mit zwei mit dem statischen bidirektionalen Wandler des elektronischen Blocks (21) verbundenen Anschlüssen versehenen induktiven Koppler (220) aufweist und eine von der äußeren Schicht abgewandte Kopplungsoberfläche aufweist.

2. Abdeckplatte gemäß Anspruch 1, **dadurch gekennzeichnet, daß** die Vorrichtung zum elektrischen Funktionalisieren einen Block zum Erzeugen elektrischer Energie aufweist.

3. Abdeckplatte gemäß Anspruch 2, **dadurch gekennzeichnet, daß** der Block zum Erzeugen elektrischer Energie
- Solarzellen (201) aufweist, die dazu bestimmt sind, eine Lichtenergie in eine elektrische Energie umzuwandeln.

4. Abdeckplatte gemäß Anspruch 1, **dadurch gekennzeichnet, daß** die Vorrichtung zum elektrischen Funktionalisieren einen Block zum Empfangen elektrischer Energie aufweist.

5. Abdeckplatte gemäß Anspruch 4, **dadurch gekennzeichnet, daß** der Block zum Empfangen elektrischer Energie eine elektronische Signalisierungsschaltung mit Licht und/oder Ton aufweist.

6. Abdeckplatte gemäß Anspruch 4, **dadurch gekennzeichnet, daß** der Block zum Empfangen elektrischer Energie eine Vorrichtung zum Aufladen eines elektrischen Geräts durch Induktion aufweist.

7. Abdeckplatte gemäß Anspruch 4, **dadurch gekennzeichnet, daß** der Block zum Empfangen elektrischer Energie eine Vorrichtung zum Zählen von Fahrzeugen aufweist.

8. Abdeckplatte gemäß Anspruch 4, **dadurch gekennzeichnet, daß** der Block zum Empfangen elektrischer Energie einen oder mehrere Anschlüsse zum Verbinden mit einem oder mehreren Netzen für drahtlose Kommunikation aufweist.

9. Abdeckplatte gemäß Anspruch 4, **dadurch gekennzeichnet, daß** der Block zum Empfangen elektrischer Energie eine Heizstruktur aufweist.

10. System zur kontaktlosen Übertragung elektrischer Energie für eine Infrastruktur wie etwa eine Chaussee vom Typ einer Straße oder einer Autobahn, eine Wand oder ein Dach, wobei die Infrastruktur durch das Hinzufügen einer Funktion vom Typ eines Generators elektrischer Energie und/oder vom Typ eines Empfängers elektrischer Energie funktionalisiert ist,
**dadurch gekennzeichnet, daß** es
- einen ersten Teil (3), der n Blöcke (32) zum kontaktlosen Übertragen von Energie aufweist, von denen jeder einen induktiven Koppler aufweist, wobei n größer als oder gleich 1 ist, wobei jeder induktive Koppler (320) eine Kopplungsoberfläche (SC1) aufweist,
- einen zweiten Teil, der n Abdeckplatten (2) aufweist, wobei jede Abdeckplatte so wie in einem der Ansprüche 1 bis 9 definiert ist,
aufweist.

11. System gemäß Anspruch 10, **dadurch gekennzeichnet, daß**
- der erste Teil (3) n Blöcke zum kontaktlosen Übertragen elektrischer Energie aufweist, wobei n größer als oder gleich 2 ist,
- jeder induktive Koppler (320) des ersten Teils durch ein Verbindungskabel (35) elektrisch mit einem angrenzenden induktiven Koppler verbunden ist.

12. System gemäß Anspruch 10 oder 11, **dadurch gekennzeichnet, daß** der erste Teil n statische Wandler (310) aufweist, die jeweils einem separaten induktiven Koppler (320) des ersten Teils zugeordnet sind.

13. System gemäß Anspruch 12, **dadurch gekennzeichnet, daß** die n statischen Wandler im ersten Teil vom Typ AC/DC sind und daß das System einen zentralen Wandler (4) vom Typ DC/AC aufweist und daß die n statischen Wandler vom Typ AC/DC mit dem zentralen Wandler parallel verbunden sind.

14. System gemäß Anspruch 13, **dadurch gekennzeichnet, daß** es ein zu den mit dem zentralen Wandler (4) verbundenen n Wandlern parallel verbundenes Modul (5) zum Speichern elektrischer Energie aufweist.

15. System gemäß Anspruch 12, **dadurch gekennzeichnet, daß** die n statischen Wandler (310) im ersten Teil vom Typ AC/AC sind.

16. System gemäß Anspruch 12, **dadurch gekennzeichnet, daß** es einen zentralen Wandler (4) vom Typ AC/AC aufweist und daß die n induktiven Koppler des ersten Teils mit dem zentralen Wandler AC/AC parallel verbunden sind.

17. System gemäß Anspruch 12, **dadurch gekennzeichnet, daß** die n statischen Wandler im ersten Teil vom Typ DC/AC sind und daß das System einen zentralen Wandler (4) vom Typ AC/AC aufweist und daß die n statischen Wandler vom Typ DC/AC mit dem zentralen Wandler parallel verbunden sind.

18. Infrastruktur wie etwa eine Chaussee vom Typ einer Straße oder einer Autobahn, eine Mauer oder ein Dach, wobei die Infrastruktur durch das Hinzufügen einer Funktion vom Typ eines Generators elektrischer Energie und/oder vom Typ eines Empfängers elektrischer Energie funktionalisiert ist und ein System zum kontaktlosen Übertragen elektrischer Energie aufweist, wobei die Infrastruktur eine untere Schicht (10) aufweist, die eine abzudeckende Oberfläche (100) aufweist und in der n Hohlräume (101) ausgeführt sind, wobei n größer als oder gleich 1 ist, wobei die Infrastruktur **dadurch gekennzeichnet ist, daß** sie
- einen ersten Teil (3), der einen in jedem Hohlraum (101) untergebrachten induktiven Koppler (320) aufweist, um eine erste Kopplungsoberfläche (SC1) zu bilden,
- einen zweiten Teil, der n wie in einem der Ansprüche 1 bis 9 definierte Abdeckplatten (2) aufweist, wobei jede Abdeckplatte (2) auf der abzudeckenden Oberfläche (100) so angeordnet ist, daß ein separater Hohlraum (101) abgedeckt wird und daß deren Außenseite nach außerhalb des Hohlraums und deren Kopplungsoberfläche (SC2) zum Inneren des Hohlraums hin, der Kopplungsoberfläche (SC1) des in dem Hohlraum untergebrachten induktiven Kopplers gegenüberliegend, gerichtet ist,
aufweist.

19. Funktionalisierte Infrastruktur gemäß Anspruch 18, **dadurch gekennzeichnet, daß**
- die abzudeckende Oberfläche (100) der unteren Schicht (10) n Hohlräume aufweist, wobei n größer als oder gleich 2 ist,
- die Infrastruktur eine Rinne (102) aufweist, die jeden Hohlraum (101) mit einem angrenzenden Hohlraum verbindet,
- der erste Teil des Systems mehrere jeweils in einem separaten Hohlraum (101) untergebrachte induktive Koppler (320) aufweist,
- die induktiven Koppler (320) von einem Hohlraum zu einem angrenzenden Hohlraum untereinander durch ein sich in der Rinne (102) erstreckendes Verbindungskabel (35) miteinander verbunden sind.

20. Funktionalisierte Infrastruktur gemäß Anspruch 18 oder 19, **dadurch gekennzeichnet, daß** die n Abdeckplatten so nebeneinander angeordnet sind, daß die äußere Oberfläche von deren äußerer Schicht in einer selben Ebene liegt.

21. Verfahren zum Installieren einer funktionalisierten Infrastruktur, wie sie in einem der Ansprüche 18 bis 20 definiert ist, wobei das Verfahren die folgenden Schritte aufweist:
- Herstellen von n Hohlräumen (101) in der unteren Schicht, wobei n größer als oder gleich 2 ist,
- Positionieren des ersten Teils derart, daß jeder Hohlraum mit einem separaten induktiven Koppler besetzt ist,
- Positionieren einer separaten Abdeckplatte (2) über einem separaten Hohlraum (101) derart, daß deren Außenseite nach außerhalb des Hohlraums und deren Kopplungsoberfläche (SC2) zum Inneren des Hohlraums hin, der Kopplungsoberfläche (SC1) des in dem Hohlraum untergebrachten induktiven Kopplers gegenüberliegend, gerichtet ist.

## Claims

1. Covering slab (2) for an infrastructure such as a roadway in the form of a road or motorway as well as a wall or a roof, said infrastructure being functionalized by the addition of a function of the electrical energy generator type and/or of the electrical energy receiver type, the covering slab being formed by a monobloc assembly comprising:
- an assembly (20) for the electrical functionalization of said slab, comprising a first layer, called an outer layer;
- an electronics block (21) connected to said electrical functionalization assembly and comprising at least one bidirectional static converter (210);
**characterized in that** said monobloc assembly also comprises:
- a contactless energy transmission block (22) comprising an inductive coupler (220) provided with two terminals connected to the bidirectional static converter of said electronics block (21) and having a coupling surface located opposite said outer layer.

2. Covering slab according to claim 1, **characterized in that** the electrical functionalization assembly comprises a block for generating electrical energy.

3. Covering slab according to claim 2, **characterized in that** the electrical energy generator block comprises
- photovoltaic cells (201) intended to convert luminous energy into an electrical energy.

4. Covering slab according to claim 1, **characterized in that** the electrical functionalization assembly comprises a block for receiving electrical energy.

5. Covering slab according to claim 4, **characterized in that** the electrical energy receiving block comprises an electronics circuit for luminous and/or sound signaling.

6. Covering slab according to claim 4, **characterized in that** the electrical energy receiving block comprises a device for charging an electrical appliance by induction.

7. Covering slab according to claim 4, **characterized in that** the electrical energy receiving block comprises a device for counting vehicles.

8. Covering slab according to claim 4, **characterized in that** the electrical energy receiving block comprises one or more terminals for connection to one or more wireless communication networks.

9. Covering slab according to claim 4, **characterized in that** the electrical energy receiving block comprises a heating structure.

10. System for contactless transmission of electrical energy for an infrastructure such as a roadway in the form of a road or motorway as well as a wall or a roof, said infrastructure being functionalized by the addition of a function of the electrical energy generator type and/or of the electrical energy receiver type, **characterized in that** it comprises:
- a first part (3) comprising n blocks (32) for contactless transmission of energy, each block comprising an inductive coupler, with n being higher than or equal to 1, each inductive coupler (320) comprising a coupling surface (SC1);
- a second part comprising n covering slab(s) (2), each covering slab being as defined in one of claims 1 to 9.

11. System according to claim 10, **characterized in that**:
- the first part (3) comprises n blocks for contactless transmission of energy, n being higher than or equal to 2;
- each inductive coupler (320) of the first part is electrically connected to an adjacent inductive coupler by means of a connection cable (35).

12. System according to claim 10 or 11, **characterized in that** the first part comprises n static converter(s) (310), each one being associated to an inductive coupler (320) distinct from the first part.

13. System according to claim 12, **characterized in that**, in the first part, the n static converter(s) are of the AC/DC type, and **in that** the system comprises a central converter (4) of the DC/AC type, and **in that** the n static converter(s) of the AC/DC type are connected in parallel to the central converter.

14. System according to claim 13, **characterized in that** it comprises a module (5) for stocking electrical energy which is connected in parallel to the n converter(s) connected to the central converter.

15. System according to claim 12, **characterized in that**, in the first part, the n static converter(s) (310) are of the AC/AC type.

16. System according to claim 12, **characterized in that** it comprises a central converter (4) of the AC/AC type, and **in that** the n inductive coupler(s) of the first part are connected in parallel to the central AC/AC converter.

17. System according to claim 12, **characterized in that**, in the first part, the n static converter(s) are of the DC/AC type, and **in that** the system comprises a central converter (4) of the AC/AC type, and **in that** the n static converter(s) of the DC/AC type are connected in parallel to the central converter.

18. Infrastructure such as a roadway in the form of a road or motorway as well as a wall or a roof, said infrastructure being functionalized by the addition of a function of the electrical energy generator type and/or of the electrical energy receiver type, and comprising a system for contactless transmission of electrical energy, said infrastructure comprising a lower layer (10) which comprises a surface (100) to be covered and in which n cavities (101) are formed, n being higher than or equal to 1, said infrastructure being **characterized in that** it comprises:
- a first part (3) comprising an inductive coupler (320) located in each cavity (101) in a way to have a first coupling surface (SC1);
- a second part comprising n covering slab(s) (2) such as defined in one of claims 1 to 9, each covering slab (2) being positioned on said surface (100) to be covered in order to cover a separate cavity (101) and to turn its outer face to the outside of said cavity and its coupling surface (SC2) to the inside of said cavity facing the coupling surface (SC1) of the inductive coupler located inside the cavity.

19. Functionalized infrastructure according to claim 18, **characterized in that**:
- said surface (100) to be covered of the lower layer (10) comprises n cavities, n being higher than or equal to 2;
- said infrastructure comprises a trench (102) linking each cavity (101) to an adjacent cavity;
- said first part of the system comprises several inductive couplers (320), each being located in a separate cavity (101);
- from one cavity to an adjacent cavity, the inductive couplers (320) are linked to one another by a connection cable (35) extending in said trench (102).

20. Functionalized infrastructure according to claim 18 or 19, **characterized in that** the n covering slabs are juxtaposed in such a way that their outer surface of their outer layer is located in a same plane.

21. Method of installing a functionalized infrastructure as defined in one of claims 18 to 20, the method comprising the steps of:
- forming n cavities (101) in the lower layer, n being higher than or equal to 2;
- positioning the first part such as to occupy each cavity with a separate inductive coupler (320);
- positioning a separate covering slab (2) on a separate cavity (101) such as to turn its outer face to the outside of the cavity and its coupling surface (SC2) to the inside of said cavity facing the coupling surface (SC1) of the inductive coupler located inside the cavity.
